# EUROPEAN PATENT APPLICATION

(11) **EP 4 726 409 A1**
(43) Date of publication of application: **15.04.2026**
(21) Application number: 25736254.1
(22) Date of filing: 02.01.2025
(51) Int. Cl.: G01R 31/382, G01R 31/396, G01R 19/12, G01R 29/24, G01R 19/10, G01R 29/12, H01M 10/48, H01M 10/052

(54) **APPARATUS AND METHOD FOR MANAGING BATTERY**

(30) Priority: 04.01.2024 KR 20240001796
(71) Applicant: LG Energy Solution, Ltd., Seoul 07335 (KR)
(72) Inventor: CHA, A-Ming, Daejeon 34122 (KR); BAE, Yoon-Jung, Daejeon 34122 (KR); KANG, Hye-Jin, Daejeon 34122 (KR)
(74) Representative: Goddar, Heinz J.
(86) International application number: PCT/KR2025/000044
(87) International publication number: WO 2025/147100

(57) **Abstract**

The battery management apparatus according to an embodiment of the present disclosure includes a profile obtaining unit configured to obtain a differential profile representing a corresponding relationship between a voltage and a differential capacity of a battery; and a control unit configured to determine a first point, which is a start point of a preset target voltage section of the differential profile, a second point having a highest differential capacity, and a third point having a lowest differential capacity in a voltage section higher than or equal to a voltage of the second point in the target voltage section, and to diagnose a state of the battery according to differential capacities of the first point, the second point, and the third point.

## Description

### TECHNICAL FIELD

This application is based on and claims priority from Korean Patent Application No. 10-2024-0001796, filed on January 4, 2024, with the Korean Intellectual Property Office, the disclosure of which is incorporated herein in its entirety by reference.

The present disclosure relates to a technology for diagnosing and managing a state of a battery, and more specifically, to a battery management apparatus and method for diagnosing a state of a battery using characteristics of a differential profile.

### BACKGROUND ART

As the demand for portable electronic products such as laptops and mobile phones that use electricity as a power source increases rapidly, and as mobile robots, electric bicycles, electric carts, and electric vehicles become more widely commercialized, research on high-performance secondary batteries capable of repeated charging and discharging is actively being conducted.

Commercially available secondary batteries include nickel-cadmium batteries, nickel hydrogen batteries, nickel-zinc batteries, lithium secondary batteries and the like. Among them, lithium secondary batteries have the advantage of being free to charge and discharge and having a very low self-discharge rate compared to nickel-based secondary batteries, with almost no memory effect. In addition, lithium secondary batteries have the characteristics of high energy density and high operating voltage, and are therefore being studied more intensively than other types of secondary batteries and are being applied more widely in actual products.

Recently, secondary batteries are widely used not only in small devices such as portable electronic devices, but also in medium and large devices such as electric vehicles and energy storage systems (ESSs).

Unlike the method of generating energy based on fossil fuels, secondary cell-based batteries generate energy through electrochemical reactions. Thus, as the charge/discharge cycle continues or is repeated, the performance at the time of initial manufacturing, i.e. the BOL (Beginning Of Life) state, cannot be maintained and gradually deteriorates.

As the battery continues to be used (charged and discharged), its usability decreases due to deterioration in capacity and output, and its safety also becomes a risk factor. Therefore, the current state of the battery needs to be accurately diagnosed for control of limited use, determination of replacement time, objective price determination for battery sharing or subscription, and improvement of efficiency in battery reuse or recycling.

Conventional representative methods for diagnosing the condition of a battery cell include methods using the behavioral characteristics of the differential profile of the battery cell or changes in peak points, and a three-electrode analysis method using a positive and negative electrode coin half cell (CHC).

A conventional method for diagnosing whether a battery cell is degraded or not using a charge depth, a positive electrode end potential, a negative electrode end potential, etc., mainly involves artificially manufacturing a negative electrode coin half cell, a positive electrode coin half cell, etc., using a reference cell having the same specifications as the battery cell to be diagnosed, and comparing their electrical behavior characteristics with the charge/discharge profile of the target cell to determine the positions of the positive electrode and the negative electrode corresponding to the degradation point. Here, the reference cell means a cell in a BOL state, which is not degraded.

However, in the case of these conventional methods, since artificial coin half cells are manufactured for each electrode, it takes a considerable amount of time. Also, since these conventional methods are largely dependent on manual work by workers, precision may be reduced due to various human errors such as deviations and errors.

Meanwhile, when the battery cell ages or a defect occurs during the manufacturing process, lithium plating (Li-plating) may occur, in which cations (Li⁺) of lithium (Li) supplied to the negative electrode are not quickly absorbed by the negative electrode and are deposited as lithium metal on the surface of the negative electrode.

In order to diagnose the occurrence of conventional lithium plating, a separate method independent of the diagnosis of the depth of charge described above must be additionally applied, so diagnosing all of them requires more time and the processing process becomes more complicated.

### DISCLOSURE

### Technical Problem

The present disclosure is designed to solve the problems of the related art, and therefore the present disclosure is directed to providing a battery management apparatus and method that may quickly and reliably diagnose a current state of a battery using a differential profile of the battery.

The technical problems that the present disclosure seeks to solve are not limited to the problems described above, and other problems not mentioned will be clearly understood by those skilled in the art from the following description.

### Technical Solution

A battery management apparatus according to one aspect of the present disclosure may comprise: a profile obtaining unit configured to obtain a differential profile representing a corresponding relationship between a voltage and a differential capacity of a battery; and a control unit configured to determine a first point, which is a start point of a preset target voltage section of the differential profile, a second point having a highest differential capacity, and a third point having a lowest differential capacity in a voltage section higher than or equal to a voltage of the second point in the target voltage section, and to diagnose a state of the battery according to differential capacities of the first point, the second point, and the third point.

The control unit may be configured to calculate a first differential capacity difference between the first point and the second point, a second differential capacity difference between the second point and the third point, and a differential capacity ratio between the first differential capacity difference and the second differential capacity difference.

The control unit may be configured to compare the differential capacity ratio with a preset first threshold value and diagnose whether lithium plating of the battery occurs based on the comparison result.

The control unit may be configured to diagnose that lithium plating occurs in the battery when the differential capacity ratio is lower than or equal to the first threshold value.

The control unit may be configured to diagnose that lithium plating occurs in the battery when the differential capacity of the second point and the differential capacity of the third point are the same.

The control unit may be configured to determine a positive electrode potential and a negative electrode potential of the battery from the differential capacity ratio based on a potential profile preset to represent a corresponding relationship between the differential capacity and positive and negative electrode potentials.

The control unit may be configured to compare the negative electrode potential with a preset second threshold value and diagnose whether lithium plating occurs in the battery based on the comparison result.

The control unit may be configured to diagnose that lithium plating occurs in the battery when the negative electrode potential is less than or equal to the second threshold value.

The control unit may be configured to determine a positive electrode charge depth and a negative electrode charge depth of the battery based on the positive electrode potential and the negative electrode potential.

A battery pack according to another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a profile obtaining step of obtaining a differential profile representing a corresponding relationship between a voltage and a differential capacity of a battery; a point determining step of determining a first point, which is a start point of a preset target voltage section of the differential profile, a second point having a highest differential capacity, and a third point having a lowest differential capacity in a voltage section higher than or equal to a voltage of the second point in the target voltage section; and a diagnosing step of diagnosing a state of the battery according to differential capacities of the first point, the second point, and the third point.

### Advantageous Effects

According to an embodiment of the present disclosure, the battery management apparatus has an advantage in that it may diagnose the current state of a battery in a non-destructive manner by comparing the differential capacities of points included in the differential profile of the battery.

In particular, the battery management apparatus has the advantage of being able to specifically diagnose whether lithium plating has occurred in the battery and the charge depth of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically of a battery management apparatus according to an embodiment of the present disclosure.
FIG. 2 is a schematic drawing of a first differential profile according to an embodiment of the present disclosure.
FIG. 3 is an enlarged drawing of the first differential profile of FIG. 2.
FIG. 4 is a schematic drawing of a second differential profile according to an embodiment of the present disclosure.
FIG. 5 is an enlarged drawing of the second differential profile of FIG. 4.
FIG. 6 is a schematic drawing of a potential profile according to an embodiment of the present disclosure.
FIG. 7 is a schematic drawing of an exemplary configuration of a battery pack including the battery management apparatus according to an embodiment of the present disclosure.
FIG. 8 is a schematic drawing of a vehicle according to another embodiment of the present disclosure.
FIG. 9 is a diagram schematically of a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

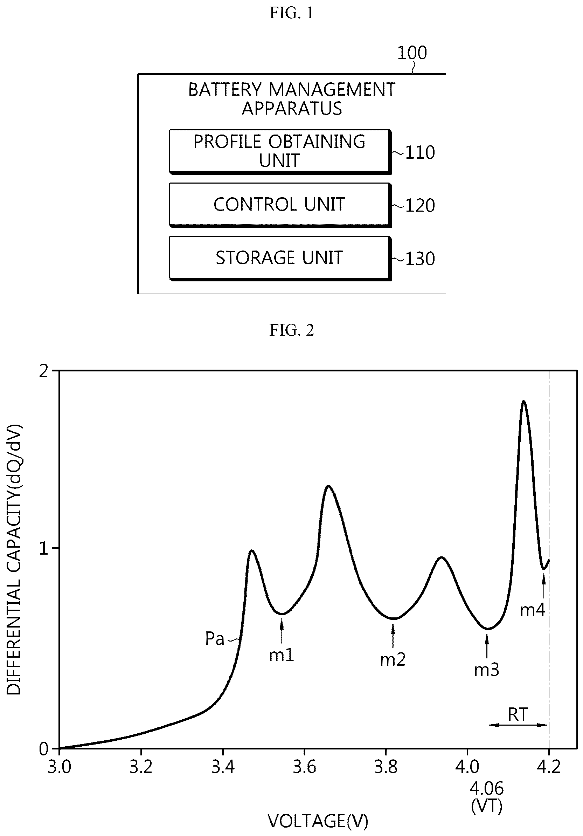

FIG. 1 is a diagram schematically showing a battery management apparatus 100 according to an embodiment of the present disclosure.

Referring to FIG. 1, the battery management apparatus 100 may include a profile obtaining unit 110, a control unit 120, and a storage unit 130.

Here, a battery means a physically separable independent cell including a negative electrode terminal and a positive electrode terminal. For example, a lithium-ion battery or a lithium polymer battery may be considered a battery. Additionally, the type of battery may be cylindrical type, prismatic type, or pouch type. In addition, a battery may mean a battery bank, a battery module, or a battery pack in which a plurality of cells are connected in series and/or in parallel. Hereinafter, for convenience of explanation, a battery is described as meaning a single independent cell.

The profile obtaining unit 110 may be configured to obtain a differential profile representing a corresponding relationship between the voltage and the differential capacity of the battery.

For example, the battery profile is a profile representing the corresponding relationship between voltage (V) and capacity (Q) when the SOC of the battery is charged from a preset start SOC or 0% to a preset end SOC or 100%. As another example, the battery profile may represent the corresponding relationship between voltage (V) and capacity (Q) when the SOC of the battery is discharged from a preset start SOC or 100% to a preset end SOC or 0%.

And, if the battery profile is differentiated with respect to voltage, a differential profile representing the corresponding relationship between the differential capacity (dQ/dV) and the voltage (V) may be generated.

For example, there is no special limitation on the C-rate in charge or discharge for generating a battery profile. However, preferably, the battery should be charged or discharged at a low rate to obtain a more accurate battery profile and differential profile. For example, a battery profile may be generated in the process of charging or discharging a battery at 0.05 C.

For example, the profile obtaining unit 110 may directly receive the differential profile of the battery from the outside. That is, the profile obtaining unit 110 may obtain the differential profile by being connected to the outside by wire and/or wirelessly and receiving the differential profile.

As another example, the profile obtaining unit 110 may directly receive the battery profile of the battery from the outside. Then, the profile obtaining unit 110 may generate a differential profile by differentiating the battery profile with respect to the voltage. That is, the profile obtaining unit 110 may obtain a differential profile by receiving the battery profile through a wired and/or wireless connection to the outside, and directly generating a differential profile from the battery profile.

As another example, the profile obtaining unit 110 may receive battery information about the voltage and capacity of the battery. Also, the profile obtaining unit 110 may generate a battery profile based on the received battery information, and generate a differential profile based on the generated battery profile. That is, the profile obtaining unit 110 may obtain a differential profile by directly generating a differential profile based on the battery information.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile to the control unit 120.

FIG. 2 is a schematic drawing of a first differential profile Pa according to an embodiment of the present disclosure. In the embodiment of FIG. 2, the first differential profile Pa may be expressed as an X-Y graph in which the X-axis is set to voltage (V) and the Y-axis is set to differential capacity (dQ/dV). Specifically, the first differential profile Pa is a differential profile representing the corresponding relationship between the voltage and differential capacity of a preset first battery.

The control unit 120 may be configured to determine a first point, which is a start point of a preset target voltage section RT in the differential profile, a second point having the highest differential capacity, and a third point having the minimum differential capacity in a voltage section higher than or equal to the voltage of the second point.

Here, the target voltage section RT is a part of the entire voltage section of the battery, and may be preset by the control unit 120.

Specifically, the control unit 120 may determine at least one local minimum point in the differential profile. The differential profile may include at least one local minimum point. This is because the differential profile is a profile obtained by differentiating the battery profile with respect to voltage, and the slope of the battery profile (the rate of change of voltage and capacity) is not a constant.

For example, in the embodiment of FIG. 2, the first differential profile Pa may include a first local minimum point m1, a second local minimum point m2, a third local minimum point m3, and a fourth local minimum point m4.

In addition, the control unit 120 may determine a local minimum point whose voltage corresponds to a preset reference voltage among the at least one determined local minimum point as a target local minimum point.

Specifically, the control unit 120 may determine a local minimum point whose corresponding voltage is near the reference voltage among the at least one local minimum point, as the target local minimum point. In other words, the control unit 120 may determine a local minimum point whose corresponding voltage is closest to the reference voltage among the at least one local minimum point, as the target local minimum point.

For example, in the embodiment of FIG. 2, it is assumed that the reference voltage is preset to 4.0 [V]. Among the four local minimum points m1, m2, m3, m4 included in the first differential profile Pa, the local minimum point whose corresponding voltage is closest to the reference voltage is the third local minimum point m3. Therefore, the control unit 120 may determine the third local minimum point m3 as the target local minimum point.

Finally, the control unit 120 may set a voltage section higher than or equal to the target voltage corresponding to the target local minimum point in the entire voltage section as the target voltage section RT.

Specifically, the control unit 120 may set the lower limit of the target voltage section RT to the target voltage of the target local minimum point, and set the upper limit of the target voltage section RT to the upper limit of the entire voltage section of the battery. That is, the control unit 120 may set the voltage section higher than or equal to the target voltage to the target voltage section RT.

For example, in the embodiment of FIG. 2, the target voltage (VT) is 4.06 [V]. The control unit 120 may set the voltage section of 4.06 [V] or more and 4.2 [V] or less as the target voltage section RT.

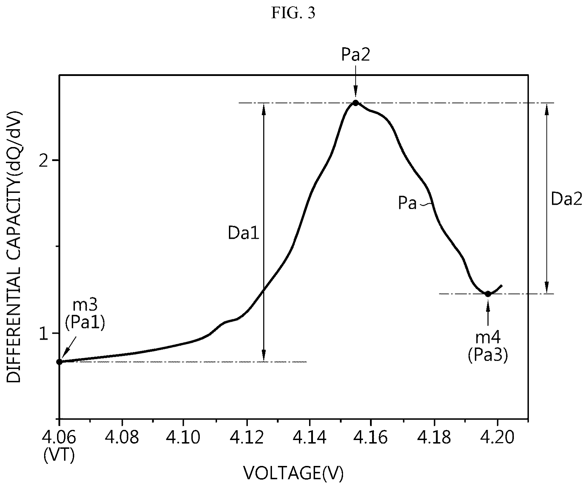

FIG. 3 is an enlarged drawing of the first differential profile Pa of FIG. 2. Specifically, FIG. 3 is a drawing that enlarges the target voltage section RT of the first differential profile Pa.

In the embodiment of FIG. 3, the control unit 120 may determine the start point of the target voltage section RT as the first point Pa1. That is, the first point Pa1 may be the target local minimum point included in the first differential profile Pa. Then, the control unit 120 may determine the point with the largest differential capacity in the target voltage section RT as the second point Pa2. Finally, the control unit 120 may determine the third point Pa3 with the smallest corresponding differential capacity in the voltage section whose corresponding voltage is higher than or equal to the voltage of the second point Pa2.

In the embodiment of FIG. 3, the second point Pa2 is a local maximum point included in the target voltage section RT. However, depending on the embodiment, the target voltage section RT may not include the local maximum point. That is, the differential capacity may not decrease in the voltage section after the first point Pa1. For example, the rate of change of the differential capacity with respect to the voltage in the voltage section after the first point Pa1 may be 0 or greater. In this case, the second point Pa2 may be determined as the point with the largest differential capacity in the target voltage section RT. In addition, the differential capacity of the third point Pa3 may be equal to the differential capacity of the second point Pa2.

The control unit 120 may be configured to diagnose the state of the battery based on the differential capacities of the first point, the second point, and the third point.

Specifically, the differential capacity is a value obtained by differentiating the capacity with respect to the voltage, and means the instantaneous rate of change of the capacity with respect to the voltage. In other words, the differential capacity is a representative factor that may also confirm the sensitive state change of the battery. In particular, as the battery deteriorates, the differential capacity of the third point may change more rapidly than the differential capacity of the first and second points. For example, as the battery deteriorates, the degree to which the differential capacity of the third point increases may be greater than the degree to which the differential capacity of the first and second points decreases. Therefore, the control unit 120 may non-destructively diagnose the current state of the battery by diagnosing the state of the battery based on the differential capacities of the first to third points.

For example, the control unit 120 may diagnose whether lithium plating occurs in the battery based on the differential capacities of the first to third points.

As another example, the control unit 120 may determine the charge depth (DOC, depth of charge) of the battery based on the differential capacities of the first to third points. Here, the charge depth is an index representing the charging performance of the battery, and is a term representing the energy storage performance of the battery. For example, as the charge depth of the battery is larger, more energy can be stored in the battery. Preferably, the control unit 120 may diagnose the current state of the battery more specifically by non-destructively diagnosing the positive electrode charge depth and the negative electrode charge depth of the battery.

The battery management apparatus 100 according to an embodiment of the present disclosure has an advantage in that it may specifically diagnose the current state of a battery in a non-destructive manner by comparing differential capacities of three points of a differential profile. In particular, the battery management apparatus 100 has an advantage in that it may specifically diagnose whether lithium plating occurs in the battery and the charge depth of the battery.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the profiles obtained by the profile obtaining unit 110 may be stored in the storage unit 130. Then, the control unit 120 may access the storage unit 130 to obtain the stored profiles.

Below, an embodiment in which the control unit 120 diagnoses whether lithium plating occurs in a battery based on the differential capacities of the first to third points is specifically described.

The control unit 120 may be configured to calculate a first differential capacity difference for the first point and the second point. And, the control unit 120 may be configured to calculate a second differential capacity difference for the second point and the third point.

For example, in the embodiment of FIG. 3, the differential capacity difference between the first point and the second point is Da1, and the differential capacity difference between the second point and the third point is Da2.

The control unit 120 may be configured to calculate a differential capacity ratio for the first differential capacity difference and the second differential capacity difference.

Specifically, the control unit 120 may calculate the value obtained by dividing the second differential capacity difference by the first differential capacity difference as the differential capacity ratio. For example, in the embodiment of FIG. 3, the control unit 120 may calculate the differential capacity ratio by calculating the formula of "Da2 ÷ Da1" or "Da2 ÷ Da1 × 100". The differential capacity ratio may be expressed as a value of 0 to 1 or as a value of 0% to 100% depending on the calculation formula. Hereinafter, for convenience of explanation, it is described that the differential capacity ratio is expressed as a value of 0% to 100%.

The control unit 120 may be configured to compare the differential capacity ratio with a preset first threshold value.

Here, the first threshold value may be preset to a value corresponding to the differential capacity ratio of the battery in which lithium plating has occurred. For example, the first threshold value may be preset to a value of 0% or more and 1% or less. Preferably, the first threshold value may be preset to a value of 0% or more and 0.5% or less. More preferably, the first threshold value may be preset to 0.2%.

Specifically, the control unit 120 may compare the size of the differential capacity ratio and the first threshold value. That is, the control unit 120 may determine whether the differential capacity ratio is less than or equal to the first threshold value or whether the differential capacity ratio exceeds the first threshold value.

For example, in the embodiments of FIGS. 2 and 3, the differential capacity ratio of the first battery is 76%. The control unit 120 may determine that the differential capacity ratio of the first battery (76%) is greater than or equal to the first threshold value (0.2%).

The control unit 120 may be configured to diagnose whether lithium plating of the battery has occurred based on the comparison result.

Specifically, the control unit 120 may be configured to diagnose that lithium plating has occurred in the battery if the differential capacity ratio is less than or equal to the first threshold value.

In the previous example, since the differential capacity ratio (76%) of the first battery is greater than or equal to the first threshold value (0.2%), the control unit 120 may diagnose that lithium plating has not occurred in the first battery.

As explained above, as the battery deteriorates, the change in differential capacity at the third point may be greater than the change in differential capacity at the first and second points. In other words, if the state of the battery has changed to the extent that the differential capacity ratio becomes lower than or equal to the first threshold value, it may be diagnosed that lithium metal has been deposited on the surface of the negative electrode of the battery even without disassembling the battery.

The battery management apparatus 100 has the advantage of being able to non-destructively diagnose whether lithium plating has occurred in a battery based on the differential capacity ratio between some points in the differential profile.

In particular, according to the present disclosure, the state of the battery may be diagnosed by analyzing only the profile for the target voltage section RT in the differential profile. Therefore, the battery management apparatus 100 has the advantage of being able to diagnose the state of the battery more quickly and using fewer system resources than when analyzing the entire differential profile.

Meanwhile, the control unit 120 may be configured to diagnose that lithium plating has occurred in the battery when the differential capacity of the second point and the differential capacity of the third point are the same.

As explained above, depending on the embodiment, the second point may not appear as a local maximum point. In this case, the second point may be determined as a point corresponding to the highest differential capacity in the target voltage section RT. And, since the second point is not a local maximum point, the differential capacity of the third point and the differential capacity of the second point may be the same.

For example, if there is no local maximum point in the target voltage section RT, the second point and the third point may be the same. In this case, the voltage of the second point and the third point is the upper limit of the target voltage section RT, and the differential capacity is the maximum differential capacity of the target voltage section RT.

As another example, if there is no local maximum point in the target voltage section RT, the second point and the third point may be different, but their differential capacities may be the same. Specifically, if the differential capacities in the voltage sections after the second point are all the same, the second point and the third point may be different. In this case, the voltage (e.g., 4.15 [V]) of the second point and the voltage (e.g., 4.2 [V]) of the third point are different, but the differential capacity of the second and third points are the maximum differential capacities of the target voltage section RT.

If the differential capacities of the second and third points are the same, the control unit 120 may calculate the second differential capacity difference as 0. And, since the second differential capacity difference is 0, the control unit 120 may calculate the differential capacity ratio as 0. In this case, since the differential capacity ratio is always less than or equal to the first threshold value, the control unit 120 may be configured to diagnose that lithium plating has occurred in the battery.

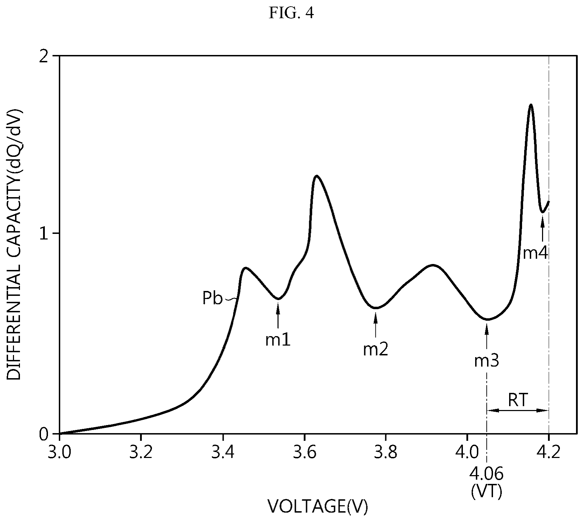

FIG. 4 is a schematic drawing of a second differential profile Pb according to an embodiment of the present disclosure. In the embodiment of FIG. 4, the second differential profile Pb may be expressed as an X-Y graph in which the X-axis is set to voltage (V) and the Y-axis is set to differential capacity (dQ/dV). Specifically, the second differential profile Pb is a differential profile that represents the corresponding relationship between the voltage and the differential capacity of a preset second battery.

In the embodiment of FIG. 4, the second differential profile Pb may include first to fourth local minimum points m1, m2, m3, m4. Since the voltage of the third local minimum point m3 is closest to the preset reference voltage (4 [V]), the control unit 120 may determine the third local minimum point m3 as the target local minimum point. The target voltage (VT) corresponding to the target local minimum point is 4.06 [V]. Therefore, the control unit 120 may set a voltage section of 4.06 [V] or more and 4.2 [V] or less as the target voltage section RT.

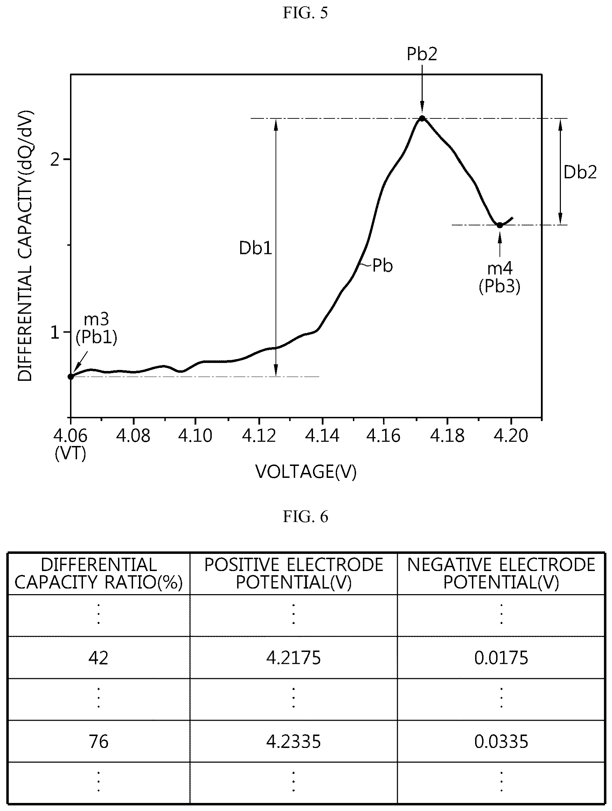

FIG. 5 is an enlarged drawing of the second differential profile Pb of FIG. 4. Specifically, FIG. 5 is an enlarged drawing of the target voltage section RT of the second differential profile Pb.

In the embodiment of FIG. 5, the control unit 120 may determine the start point of the preset target voltage section RT in the differential profile as the first point Pb1. Then, the control unit 120 may determine the point with the largest differential capacity in the target voltage section RT as the second point Pb2. Finally, the control unit 120 may determine the point with the smallest corresponding differential capacity in the voltage section higher than or equal to the voltage of the second point Pb2 as the third point Pb3.

In addition, the control unit 120 may calculate the first differential capacity difference (Db1) between the first point and the second point, calculate the second differential capacity difference (Db2) between the second point and the third point, and calculate the differential capacity ratio of the second differential capacity difference (Db2) to the first differential capacity difference (Db1).

Finally, the control unit 120 may diagnose the state of the second battery based on the calculated differential capacity ratio.

For example, in the embodiments of FIGS. 4 and 5, the differential capacity ratio of the second battery is 42%. The control unit 120 may determine that the differential capacity ratio (42%) of the second battery is greater than or equal to the first threshold value (0.2%). Therefore, the control unit 120 may diagnose that lithium plating has not occurred in the second battery.

Below, an embodiment is specifically described in which the control unit 120 determines the positive and negative electrode charge depth of the battery based on the differential capacities of the first to third points.

The control unit 120 may be configured to determine the positive electrode potential and the negative electrode potential of the battery from the differential capacity ratio based on a potential profile preset to represent the corresponding relationship between the differential capacity and the positive and negative electrode potentials.

Here, the potential profile may be preset to represent the corresponding relationship between the differential capacity ratio, the positive electrode potential, and the negative electrode potential. Specifically, the positive electrode potential and the negative electrode potential corresponding to the differential capacity ratio of the battery may be predetermined through an experiment using a three-electrode cell or a coin half cell (CHC). The control unit 120 may determine the positive electrode potential and the negative electrode potential corresponding to the differential capacity ratio calculated for the battery by referring to the preset potential profile.

FIG. 6 is a schematic drawing of a potential profile according to an embodiment of the present disclosure. Specifically, the potential profile of FIG. 6 is a potential profile preset to correspond to a battery with a charge end voltage (or upper limit voltage) of 4.2 [V].

Referring to the previous example, the differential capacity ratio of the first battery was calculated as 76%, and the differential capacity ratio of the second battery was calculated as 42%. The control unit 120 may determine the positive electrode potential of the first battery as 4.2335 [V], and the negative electrode potential as 0.0335 [V]. In addition, the control unit 120 may determine the positive electrode potential of the second battery as 4.2175 [V], and the negative electrode potential as 0.0175 [V].

Specifically, the control unit 120 may be configured to determine the positive electrode charge depth and the negative electrode charge depth of the battery based on the positive electrode potential and the negative electrode potential.

For example, the first battery may be charged until the positive electrode potential reaches 4.2335 [V] and the negative electrode potential reaches 0.0335 [V]. The control unit 120 may calculate the positive electrode charge amount until the positive electrode potential reaches 4.2335 [V] by referring to the positive electrode profile corresponding to the first battery. Then, the control unit 120 may determine the calculated positive electrode charge amount as the positive electrode charge depth. Similarly, the control unit 120 may calculate the negative electrode charge amount until the negative electrode potential reaches 0.0335 [V] by referring to the negative electrode profile corresponding to the first battery. Then, the control unit 120 may determine the calculated negative electrode charge amount as the negative electrode charge depth.

Here, the positive electrode profile corresponding to the battery is a profile representing the current positive electrode state of the battery, and may represent a corresponding relationship between the positive electrode capacity and the positive electrode potential. For example, a reference positive electrode profile preset for a battery in the BOL (Beginning of Life) state or a theoretically ideal reference cell is provided, and the positive electrode profile may be prepared by adjusting (or fitting) the reference positive electrode profile to correspond to the current state of the battery. Similarly, the negative electrode profile corresponding to the battery is a profile representing the current negative electrode state of the battery, and may represent a corresponding relationship between the negative electrode capacity and the negative electrode potential. For example, a reference negative electrode profile preset for a battery in the BOL state or a theoretically ideal reference cell is provided, and the negative electrode profile may be prepared by adjusting (or fitting) the reference negative electrode profile to correspond to the current state of the battery. Since a conventional method may be applied to the adjustment process of the reference positive electrode profile and the reference negative electrode profile, a detailed description thereof will be omitted.

The battery management apparatus 100 according to an embodiment of the present disclosure has an advantage in that it may diagnose the current state of the battery from various aspects by determining positive and negative electrode potentials and positive and negative electrode charge depths based on a differential capacity ratio. That is, according to the present disclosure, not only whether lithium plating has occurred but also specific information on the positive and negative electrodes is provided, so the state of the battery may be objectively diagnosed based on various pieces of information.

Meanwhile, the control unit 120 may be configured to compare the negative electrode potential with a preset second threshold value.

Here, the second threshold value may be preset to a value corresponding to the negative electrode potential of the battery in which lithium plating occurs. In general, it is known that when the negative electrode potential is lower than or equal to a predetermined value, a lithium electrodeposition reaction occurs. That is, when the negative electrode potential decreases to the second threshold value or below, a lithium plating phenomenon may occur. For example, the second threshold value may be preset to a value lower than or equal to 0 [V]. Preferably, the second threshold value may be preset to a value lower than or equal to -0.1 [V]. More preferably, the second threshold value may be preset to - 0.1 [V]. Hereinafter, for convenience of explanation, it is described that the second threshold value is -0.1 [V].

Specifically, the control unit 120 may compare the magnitude of the negative electrode potential and the second threshold value. That is, the control unit 120 may determine whether the negative electrode potential is less than or equal to the second threshold value or whether the negative electrode potential exceeds the second threshold value.

For example, in the embodiment of FIG. 6, the negative electrode potential of the first battery is 0.0335 [V], and the negative electrode potential of the second battery is 0.0175 [V]. The control unit 120 may determine that the negative electrode potentials of the first battery and the second battery are all greater than or equal to the second threshold value (-0.1 [V]).

The control unit 120 may be configured to diagnose whether lithium plating occurs in the battery based on the comparison result. That is, the control unit 120 may diagnose whether lithium plating occurs in the battery using not only the differential capacity ratio of the battery but also the negative electrode potential.

Specifically, the control unit 120 may be configured to diagnose that lithium plating has occurred in the battery if the negative electrode potential is less than or equal to the second threshold value.

In the previous example, since the negative electrode potential (0.0335 [V]) of the first battery is greater than or equal to the second threshold value (-0.1 [V]), the control unit 120 may diagnose that lithium plating has not occurred in the first battery. In addition, since the negative electrode potential (0.0175 [V]) of the second battery is greater than or equal to the second threshold value (-0.1 [V]), the control unit 120 may diagnose that lithium plating has not occurred in the second battery.

That is, the battery management apparatus 100 may diagnose the state of the battery more objectively and complementarily by diagnosing the state of the battery based on the differential capacity ratio and/or negative electrode potential.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the components included in the conventional BMS. For example, the profile obtaining unit 110, the control unit 120, and the storage unit 130 of the battery management apparatus 100 may be implemented as components of the BMS.

In addition, the battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

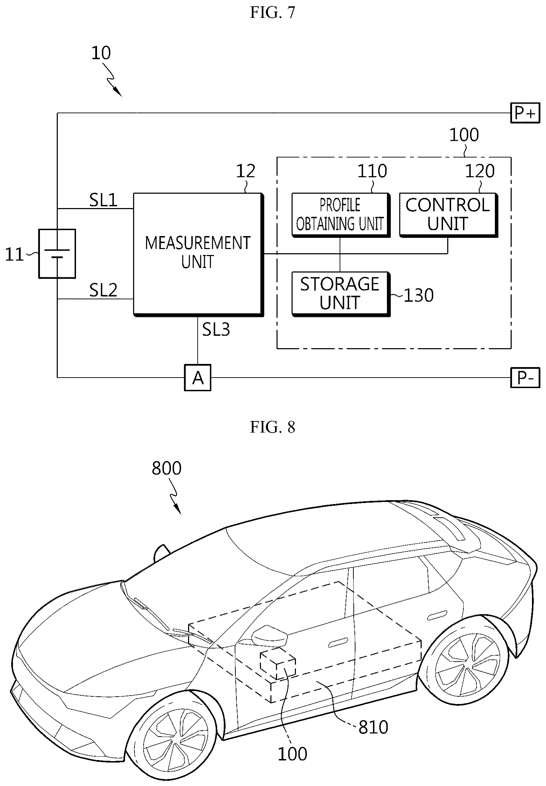

FIG. 7 is a diagram showing an exemplary configuration of a battery pack including the battery management apparatus 100 according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

A measurement unit 12 may be connected to a first sensing line SL1, a second sensing line SL2, and a third sensing line SL3. Specifically, the measurement unit 12 may be connected to a positive electrode terminal of the battery 11 through the first sensing line SL1, and may be connected to a negative electrode terminal of the battery 11 through the second sensing line SL2. The measurement unit 12 may measure the voltage of the battery 11 based on the voltage measured at each of the first sensing line SL1 and the second sensing line SL2.

In addition, the measurement unit 12 may be connected to an ampere meter A through the third sensing line SL3. For example, the ampere meter A may be an ammeter or a shunt resistor capable of measuring the charging current and the discharging current of the battery 11. The measurement unit 12 may calculate the charge amount by measuring the charging current of the battery 11 through the third sensing line SL3. Also, the measurement unit 12 may calculate the discharge amount by measuring the discharge current of the battery 11 through the third sensing line SL3.

For example, the profile obtaining unit 110 may receive a differential profile representing a corresponding relationship between the voltage and differential capacity of the battery 11 from the measurement unit 12.

As another example, the profile obtaining unit 110 may receive a battery profile representing a corresponding relationship between the voltage and capacity of the battery 11 from the measurement unit 12. Then, the profile obtaining unit 110 may differentiate the battery profile with respect to voltage to generate a differential profile.

As still another example, the profile obtaining unit 110 may receive battery information about the voltage and capacity of the battery 11 from the measurement unit 12. Then, the profile obtaining unit 110 may generate a battery profile and a differential profile from the received battery information.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 8 is a schematic drawing of a vehicle 700 according to another embodiment of the present disclosure.

Referring to FIG. 8, the battery pack according to an embodiment of the present disclosure may be included in a vehicle 800, such as an electric vehicle (EV) or a hybrid vehicle (HV). In addition, the battery pack 810 may drive the vehicle 800 by supplying power to a motor through an inverter provided in the vehicle 800. Here, the battery pack 810 may include the battery management apparatus 100. That is, the vehicle 800 may include the battery management apparatus 100. In this case, the battery management apparatus 100 may be an onboard device included in the vehicle 800.

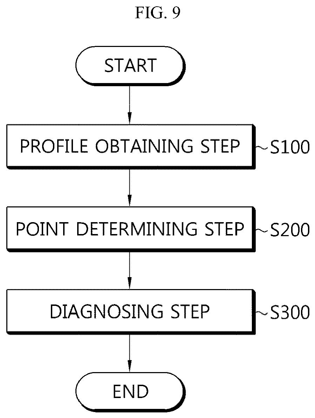

FIG. 9 is a diagram schematically showing a battery management method according to still another embodiment of the present disclosure.

Referring to FIG. 9, the battery management method may include a profile obtaining step (S100), a point determining step (S200), and a diagnosing step (S300).

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a differential profile representing a corresponding relationship between the voltage and differential capacity of the battery, and may be performed by the profile obtaining unit 110.

For example, the profile obtaining unit 110 may directly receive the differential profile of the battery from the outside. That is, the profile obtaining unit 110 may obtain the differential profile by being connected to the outside by wire and/or wirelessly and receiving the differential profile.

As another example, the profile obtaining unit 110 may directly receive the battery profile of the battery from the outside. Then, the profile obtaining unit 110 may generate a differential profile by differentiating the battery profile with respect to the voltage. That is, the profile obtaining unit 110 may obtain a differential profile by receiving the battery profile through a wired and/or wireless connection to the outside, and directly generating a differential profile from the battery profile.

As another example, the profile obtaining unit 110 may receive battery information about the voltage and capacity of the battery. Also, the profile obtaining unit 110 may generate a battery profile based on the received battery information, and generate a differential profile based on the generated battery profile. That is, the profile obtaining unit 110 may obtain a differential profile by directly generating a differential profile based on the battery information.

The point determining step (S200) is a step of determining a first point, which is a start point of a preset target voltage section RT of the differential profile, a second point having the highest differential capacity, and a third point having the minimum differential capacity in a voltage section higher than or equal to the voltage of the second point, and may be performed by the control unit 120.

For example, in the embodiment of FIG. 3, the control unit 120 may determine the start point of the target voltage section RT as the first point Pa1. Then, the control unit 120 may determine the point with the largest differential capacity in the target voltage section RT as the second point Pa2. Finally, the control unit 120 may determine the point with the smallest corresponding differential capacity in the voltage section higher than or equal to the voltage of the second point Pa2 as the third point Pa3.

As another example, in the embodiment of FIG. 5, the control unit 120 may determine a start point of a preset target voltage section RT in the differential profile as the first point Pb1. Then, the control unit 120 may determine a point with the largest differential capacity in the target voltage section RT as the second point Pb2. Finally, the control unit 120 may determine a point with the smallest corresponding differential capacity in a voltage section higher than or equal to the voltage of the second point Pb2 as the third point Pb3.

The diagnosing step (S300) is a step for diagnosing the state of the battery based on the differential capacities of the first point, the second point, and the third point, and may be performed by the control unit 120.

For example, the control unit 120 may diagnose whether lithium plating has occurred in the battery based on the differential capacities of the first to third points. Specifically, the control unit 120 may be configured to calculate a first differential capacity difference for the first point and the second point, and a second differential capacity difference for the second point and the third point. In addition, the control unit 120 may be configured to calculate a differential capacity ratio for the first differential capacity difference and the second differential capacity difference. Finally, the control unit 120 may diagnose whether lithium plating has occurred in the battery based on a result of comparing the calculated differential capacity ratio with a preset first threshold value.

As another example, the control unit 120 may determine the positive electrode potential and the negative electrode potential of the battery based on the calculated differential capacity ratio. In addition, the control unit 120 may determine the positive electrode charge depth of the battery based on the determined positive electrode potential, and may determine the negative electrode charge depth of the battery based on the determined negative electrode potential.

As still another example, the control unit 120 may diagnose whether lithium plating has occurred in the battery based on the result of comparing the determined negative electrode potential with a preset second threshold value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measurement unit
100: battery management apparatus
110: profile obtaining unit
120: control unit
130: storage unit
800: vehicle
810: battery pack

## Claims

1. A battery management apparatus, comprising:
a profile obtaining unit configured to obtain a differential profile representing a corresponding relationship between a voltage and a differential capacity of a battery; and
a control unit configured to determine a first point, which is a start point of a preset target voltage section of the differential profile, a second point having a highest differential capacity, and a third point having a lowest differential capacity in a voltage section higher than or equal to a voltage of the second point in the target voltage section, and to diagnose a state of the battery according to differential capacities of the first point, the second point, and the third point.

2. The battery management apparatus according to claim 1,
wherein the control unit is configured to calculate a first differential capacity difference between the first point and the second point, a second differential capacity difference between the second point and the third point, and a differential capacity ratio between the first differential capacity difference and the second differential capacity difference.

3. The battery management apparatus according to claim 2,
wherein the control unit is configured to compare the differential capacity ratio with a preset first threshold value and diagnose whether lithium plating of the battery occurs based on the comparison result.

4. The battery management apparatus according to claim 3,
wherein the control unit is configured to diagnose that lithium plating occurs in the battery when the differential capacity ratio is lower than or equal to the first threshold value.

5. The battery management apparatus according to claim 1,
wherein the control unit is configured to diagnose that lithium plating occurs in the battery when the differential capacity of the second point and the differential capacity of the third point are the same.

6. The battery management apparatus according to claim 2,
wherein the control unit is configured to determine a positive electrode potential and a negative electrode potential of the battery from the differential capacity ratio based on a potential profile preset to represent a corresponding relationship between the differential capacity and positive and negative electrode potentials.

7. The battery management apparatus according to claim 6,
wherein the control unit is configured to compare the negative electrode potential with a preset second threshold value and diagnose whether lithium plating occurs in the battery based on the comparison result.

8. The battery management apparatus according to claim 7,
wherein the control unit is configured to diagnose that lithium plating occurs in the battery when the negative electrode potential is less than or equal to the second threshold value.

9. The battery management apparatus according to claim 6,
wherein the control unit is configured to determine a positive electrode charge depth and a negative electrode charge depth of the battery based on the positive electrode potential and the negative electrode potential.

10. A battery pack comprising the battery management apparatus according to any one of claims 1 to 9.

11. A vehicle comprising the battery management apparatus according to any one of claims 1 to 9.

12. A battery management method comprising:
a profile obtaining step of obtaining a differential profile representing a corresponding relationship between a voltage and a differential capacity of a battery;
a point determining step of determining a first point, which is a start point of a preset target voltage section of the differential profile, a second point having a highest differential capacity, and a third point having a lowest differential capacity in a voltage section higher than or equal to a voltage of the second point in the target voltage section; and
a diagnosing step of diagnosing a state of the battery according to differential capacities of the first point, the second point, and the third point.
